# EUROPÄISCHE PATENTSCHRIFT

(11) **EP 2 286 469 B1**
(45) Veröffentlichungstag und Bekanntmachung des Hinweises auf die Patenterteilung: **04.01.2012**
(21) Anmeldenummer: 09761309.5
(22) Anmeldetag: 28.05.2009
(51) Int. Cl.: H01L 33/00, H01L 21/225

(54) **HALBLEITERKÖRPER UND VERFAHREN ZUR HERSTELLUNG EINES HALBLEITERKÖRPERS**
SEMICONDUCTOR BODY AND METHOD FOR PRODUCING A SEMICONDUCTOR BODY
CORPS EN SEMICONDUCTEUR ET PROCEDE DE FABRICATION D' UN CORPS EN SEMICONDUCTEUR

(30) Priorität: 13.06.2008 DE 102008028345
(43) Veröffentlichungstag der Anmeldung: 23.02.2011
(73) Patentinhaber: OSRAM Opto Semiconductors GmbH, 93055 Regensburg (DE)
(72) Erfinder: STRASSBURG, Martin, 93105 Tegernheim (DE); LUGAUER, Hans-Jürgen, 93161Sinzing (DE); GROLIER, Vincent, 80639 München (DE); HAHN, Berthold, 93155 Hemau (DE); FLÖTER, Richard, 93105 Tegernheim (DE)
(74) Vertreter: Epping - Hermann - Fischer
(86) Internationale Anmeldenummer: PCT/DE2009/000756
(87) Internationale Veröffentlichungsnummer: WO 2009/149687

(56) Entgegenhaltungen:
- US-A1- 2002 187 568
- US-A1- 2004 058 465
- US-A1- 2004 104 399

## Beschreibung

Die vorliegende Anmeldung betrifft einen Halbleiterkörper und ein Verfahren zur Herstellung eines Halbleiterkörpers.

Bei Leuchtdioden auf der Basis von Nitrid-Verbindungshalbleitern werden oftmals Halbleiterschichten eingesetzt, die für eine p-Leitung mit Magnesium dotiert sind. Während der Herstellung können die Halbleiterschichten einem Aktivierungs-Schritt unterzogen werden, bei dem in die Schicht eingebauter Wasserstoff von dem Magnesium getrennt wird. Insbesondere bei vergrabenen, mit Magnesium dotierten Halbleiterschichten kann eine unzureichende Aktivierung des Magnesiums zu einer erhöhten Betriebsspannung der Leuchtdiode führen.

Es ist eine Aufgabe, einen Halbleiterkörper anzugeben, der verbesserte optoelektronische Eigenschaften aufweist. Insbesondere soll die p-leitende Halbeiterschicht einen verbesserten Aktivierungsgrad aufweisen. Weiterhin soll ein Verfahren zur Herstellung eines Halbleiterkörpers angegeben werden.

Die Druckschrift US2004/0058465 A1 offenbart einen Halbleiterkörper nach dem Oberbegriff des Patentansprunchs 1, sowie ein Herstellungsverfahren nach dem Oberbegriff des Patentansprunchs 13. Diese Aufgaben werden durch die Gegenstände der unabhängigen Patentansprüche gelöst. Weitere Ausgestaltungen und Weiterbildungen sind Gegenstand der abhängigen Patentansprüche.

Gemäß einer Ausführungsform weist ein Halbleiterkörper eine n-leitende Halbleiterschicht und eine p-leitende Halbleiterschicht auf. Die p-leitende Halbleiterschicht enthält einen p-Dotierstoff. Die n-leitende Halbleiterschicht enthält einen n-Dotierstoff und einen weiteren Dotierstoff.

Mittels des weiteren Dotierstoffs ist der Aktivierungsgrad der p-leitenden Halbleiterschicht dauerhaft steigerbar. Das heißt, der Anteil der Atome des p-Dotierstoffs, die Löcher als Ladungsträger zur Verfügung stellen, ist erhöht.

Insbesondere kann die n-leitende Halbleiterschicht eine zumindest lokal erhöhte Durchlässigkeit für Wasserstoff aufweisen. Die Löslichkeit von Wasserstoff in der n-leitenden Halbleiterschicht kann mittels des weiteren Dotierstoffs erhöht sein. Bei der Aktivierung der p-leitenden Halbleiterschicht kann Wasserstoff durch die über der p-leitenden Schicht angeordnete n-leitende Halbleiterschicht hindurchtreten. Die Diffusion von Wasserstoff durch die n-leitende Halbleiterschicht kann also durch den weiteren Dotierstoff erleichtert werden.

Zwischen der p-leitenden Halbleiterschicht und der n-leitenden Halbleiterschicht ist ein aktiver, zur Strahlungserzeugung vorgesehener Bereich und/oder ein Tunnelkontakt ausgebildet. Mit anderen Worten befindet sich zwischen der p-leitenden Halbleiterschicht und der n-leitenden Halbleiterschicht ein funktioneller pn-Übergang. Der funktionelle pn-Übergang dient entweder zur Strahlungserzeugung - im Falle des aktiven Bereichs - oder zur elektrischen Verbindung einer p-dotierten Schicht mit einer n-dotierten Schicht - im Falle des Tunnelübergangs. Der Tunnelübergang kann dabei beispielsweise eine hoch p-dotierte Tunnelschicht und eine hoch n-dotierte Tunnelschicht aufweisen.

Die pleitende Halbleiterschicht ist von zumindest einer weiteren Halbleiterschicht bedeckt. Bei der weiteren Halbleiterschicht kann es sich beispielsweise um eine Halbleiterschicht mit dem aktiven, zur Strahlungserzeugung vorgesehenen Bereich oder mit dem Tunnelkontakt handeln. In jedem Fall ist die p-leitende Halbleiterschicht dann vergraben und befindet sich nicht an einer Außenseite des Halbleiterkörpers. Das heißt, die p-leitende Halbleiterschicht liegt nicht frei.

In einer Ausgestaltung des Halbleiterkörpers ist die p-leitende Halbleiterschicht zwischen dem aktiven Bereich und einem Träger oder einem Aufwachssubstrat angeordnet. Auf der der p-leitenden Halbleiterschicht abgewandten Seite des aktiven Bereichs ist dann die n-leitende Halbleiterschicht mit dem n-Dotierstoff und dem weiteren Dotierstoff angeordnet. In jedem Fall ist die p-leitende Halbleiterschicht dann vergraben und von außerhalb des Halbleiterkörpers nicht frei zugänglich.

In einer Ausgestaltung des Halbleiterkörpers weist die n-leitende Halbleiterschicht eine Dicke von wenigstens 5 nm, vorzugsweise wenigstens 10 nm, besonders bevorzugt von wenigstens 20 nm auf. Eine derartige n-leitende Halbleiterschicht ohne weiteren Dotierstoff, also nur mit einem n-Dotierstoff, ist für Wasserstoff undurchlässig. Erst durch die Hinzugabe des weiteren Dotierstoffs wird eine Durchlässigkeit der Schicht für Wasserstoff erreicht. Vorteilhaft kann die n-leitende Halbleiterschicht vorliegend dicker als 20 nm ausgebildet werden, was beispielsweise die Querleitfähigkeit der n-leitenden Halbleiterschicht verbessert.

Der Halbleiterkörper basiert vorzugsweise auf einem Nitrid-Verbindungshalbleitermaterial.

"Auf Nitrid-Verbindungshalbleitern basierend" bedeutet im vorliegenden Zusammenhang, dass die aktive EpitaxieSchichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1 gilt. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

In einer bevorzugten Ausgestaltung ist der weitere Dotierstoff bezüglich des Materials und/oder der Konzentration derart in der n-leitenden Halbleiterschicht ausgebildet, dass eine Durchlässigkeit der n-leitenden Halbleiterschicht für Wasserstoff erhöht ist. Bei der Aktivierung der p-leitenden Halbleiterschicht kann Wasserstoff verbessert durch die n-leitende Halbleiterschicht hindurchtreten. Der Grad der Aktivierung der p-leitenden Halbleiterschicht kann so gesteigert werden. Die Löslichkeit von Wasserstoff in der n-leitenden Halbleiterschicht kann hierbei mittels des weiteren Dotierstoffs erhöht sein.

In einer weiteren bevorzugten Ausgestaltung wirkt der weitere Dotierstoff in der n-leitenden Halbleiterschicht als Akzeptor.

Bei einem Nitrid-Verbindungshalbleitermaterial eignen sich als Akzeptoren Elemente aus der ersten und zweiten Hauptgruppe des Periodensystems. Durch Einbau eines solchen Elements auf einem Gitterplatz eines Gruppe-III-Elements in den Kristall kann die p-Leitung des Halbleitermaterials erhöht werden.

Durch den als Akzeptor wirkenden weiteren Dotierstoff wird die n-Dotierung mittels des weiteren Dotierstoffs teilweise kompensiert. Es hat sich herausgestellt, dass der Akzeptor als weiterer Dotierstoff trotz der teilweisen Kompensation der n-Dotierung in der n-leitenden Halbleiterschicht aufgrund des gesteigerten Aktivierungsgrads des p-Dotierstoffs in der p-leitenden Halbleiterschicht insgesamt eine Verbesserung der optoelektronischen Eigenschaften des Halbleiterkörpers bewirkt.

In einer bevorzugten Ausgestaltung ist der weitere Dotierstoff Magnesium. In die n-leitende Halbleiterschicht eingebrachte Magnesiumatome können zu einer, insbesondere lokal, erhöhten Löslichkeit von Wasserstoff in dieser Halbleiterschicht führen. Wasserstoff kann vereinfacht durch die n-leitende Halbleiterschicht hindurch diffundieren und so zu einer einem Aufwachssubstrat abgewandten Endfläche des Halbleiterkörpers gelangen und weiterhin bevorzugt aus diesem austreten.

In einer weiteren Ausgestaltung ist der weitere Dotierstoff der n-leitenden Halbleiterschicht gleich dem p-Dotierstoff der p-leitenden Halbleiterschicht. Insbesondere können der weitere Dotierstoff und der p-Dotierstoff jeweils Magnesium sein.

Die Konzentration des weiteren Dotierstoffs beträgt vorzugsweise höchstens 50 % der Konzentration des n-Dotierstoffs. Bei einer Dotierkonzentration von maximal 50 % des weiteren Dotierstoffs bezogen auf den n-Dotierstoff kann eine wesentliche Beeinträchtigung der optoelektronischen Eigenschaften des Halbleiterkörpers aufgrund zu starker Kompensation der n-Dotierung vermieden werden.

Weiterhin bevorzugt beträgt die Konzentration des weiteren Dotierstoffs in der n-leitenden Halbleiterschicht mindestens 1 x 10¹⁶ cm⁻³. Insbesondere kann die Konzentration zwischen einschließlich 1 x 10¹⁷ cm⁻³ und einschließlich 5 x 10¹⁸ cm⁻³, besonders bevorzugt zwischen einschließlich 1 x 10¹⁷ cm⁻³ und einschließlich 2 x 10¹⁸ cm⁻³, betragen. So kann die Durchlässigkeit der n-leitenden Halbleiterschicht für Wasserstoff erhöht sein, ohne dass eine maßgebliche Verschlechterung der optischen Qualität der n-leitenden Halbleiterschicht auftritt.

Der Halbleiterkörper weist vorzugsweise einen zur Erzeugung von Strahlung vorgesehenen aktiven Bereich auf. Der aktive Bereich kann insbesondere zwischen der p-leitenden Halbleiterschicht und der n-leitenden Halbleiterschicht ausgebildet sein.

In einer bevorzugten Weiterbildung weist der Halbleiterkörper einen weiteren aktiven Bereich auf, wobei der aktive Bereich und der weitere aktive Bereich jeweils zur Erzeugung von Strahlung vorgesehenen sind. Mittels des weiteren aktiven Bereichs kann die insgesamt erzeugbare Strahlungsleistung bei gleicher Grundfläche des Halbleiterkörpers gesteigert werden. Insbesondere kann die n-leitende Halbleiterschicht zwischen dem aktiven Bereich und dem weiteren aktiven Bereich ausgebildet sein. Die von der n-leitenden Halbleiterschicht bedeckte p-leitende Halbleiterschicht ist bei der Herstellung des Halbleiterkörpers verbessert aktivierbar.

Mittels des Halbleiterkörpers kann ein Halbleiterchip gebildet sein. Der Halbleiterchip kann beispielsweise als Lumineszenzdioden-Chip oder als Laserdioden-Chip ausgeführt sein.

In einer bevorzugten Ausgestaltung ist ein Aufwachssubstrat für den Halbleiterkörper vollständig oder zumindest bereichsweise entfernt. Ein solcher Halbeiterchip wird auch als Dünnfilm-Halbleiterchip bezeichnet.

Ein Dünnfilm-Halbleiterchip, etwa ein Dünnfilm-Leuchtdioden-Chip, kann sich weiterhin im Rahmen der vorliegenden Anmeldung durch mindestens eines der folgenden charakteristischen Merkmale auszeichnen:
- an einer zu einem Trägerelement hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20 µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug in die vorliegende Anmeldung aufgenommen wird.

Bei einem Verfahren zur Herstellung eines Halbleiterkörpers mit einer n-leitenden Halbleiterschicht und einer p-leitenden Halbleiterschicht wird gemäß einer Ausführungsform eine Halbleiterschicht abgeschieden, die einen p-Dotierstoff und Wasserstoff enthält. Eine n-leitende Halbleiterschicht wird, vorzugsweise auf der p-leitenden Halbleiterschicht, abgeschieden, wobei die n-leitende Halbleiterschicht einen n-Dotierstoff und einen weiteren Dotierstoff enthält. Zum Ausbilden der p-leitenden Halbleiterschicht wird der p-Dotierstoff der Halbleiterschicht aktiviert, wobei Wasserstoff aus der Halbleiterschicht durch die n-leitende Halbleiterschicht hindurchtritt.

Ein Verfahren zur Herstellung eines Halbleiterchips mit einem erhöhten Grad der Aktivierung der p-leitenden Halbleiterschicht ist so auf einfache Weise realisiert.

Die Aktivierung erfolgt vorzugsweise thermisch. Durch Erhitzen des Halbleiterkörpers kann der Wasserstoff auf einfache Weise aus dem Halbleiterkörper ausgetrieben werden.

Die n-leitende Halbleiterschicht kann auf der Halbleiterschicht abgeschieden werden, wobei die n-leitende Halbleiterschicht die Halbleiterschicht vollständig bedecken kann. Aufgrund der verbesserten Durchlässigkeit der n-leitenden Halbleiterschicht für Wasserstoff kann also auch eine, insbesondere vollständig, vergrabene p-leitende Halbleiterschicht mit hoher Effizienz aktiviert werden. Somit können vereinfacht Halbleiterkörper abgeschieden werden, bei denen die p-leitende Halbleiterschicht vor dem aktiven Bereich und vor der n-leitenden Halbleiterschicht abgeschieden wird. In diesem Fall ist die p-leitende Halbleiterschicht also näher am Aufwachssubstrat als die n-leitende Halbleiterschicht.

In einer Ausgestaltung des Halbleiterkörpers weist der Halbleiterkörper eine polarisationsinvertierte Struktur auf, mit folgender Abfolge von Schichten: Der Halbleiterkörper umfasst ein Aufwachssubstrat, auf das die p-leitende Halbleiterschicht angeordnet ist. Auf der dem Aufwachssubstrat abgewandten Seite der p-leitenden Halbleiterschicht ist der aktive Bereich angeordnet. Auf der dem aktiven Bereich abgewandten Seite der p-leitenden Halbleiterschicht ist die n-leitende Halbleiterschicht mit einem n-Dotierstoff und einem weiteren Dotierstoff angeordnet. Eine derartige, so genannte polaritätsinvertierte Struktur ist beispielsweise in der Druckschrift WO 2007/012327 beschrieben, deren Offenbarungsgehalt hiermit unter Rückbezug aufgenommen wird.

Auch bei der polaritätsinvertierten Struktur ist die p-leitende Halbleiterschicht vergraben, das heißt, sie ist von weiteren Halbleiterschichten bedeckt. Bei der Aktivierung der p-leitenden Halbleiterschicht muss Wasserstoff also durch die weiteren Halbleiterschichten gelangen, insbesondere durch die n-leitende Halbleiterschicht gelangen, um den Halbleiterkörper verlassen zu können. Dies ist vorliegend durch die Codotierung der n-leitenden Halbleiterschicht mit einem weiteren Dotierstoff, beispielsweise dem p-Dotierstoff, der auch in der p-leitenden Halbleiterschicht Verwendung findet, möglich.

Insbesondere bei einem auf Nitrid-Verbindungshalbleitermaterial basierenden Halbleiterkörper kann eine Abfolge von Schichten, bei der zunächst die n-leitende Halbleiterschicht und nachfolgend der aktive Bereich und die p-leitende Halbleiterschicht abgeschieden werden, dazu führen, dass piezoelektrische Felder die Injektion von Ladungsträgern in den aktiven Bereich erschweren. Bedingt dadurch weisen Halbleiterchips mit solchen Halbleiterkörpern eine interne Quanteneffizienz auf, die mit der Dichte des in den Halbleiterchip eingeprägten Stroms stark abfällt.

Dagegen kann eine Abfolge, bei der zunächst die p-leitende Halbleiterschicht und nachfolgend der aktive Bereich und die n-leitende Halbleiterschicht abgeschieden werden, die Polung der piezoelektrischen Felder ausnützen, um den Einfang von Ladungsträgern im aktiven Bereich zu unterstützen. Die piezoelektrischen Felder tragen also bei dieser Reihenfolge des Schichtaufbaus zu einem verbesserten Einfang von Ladungsträgern im aktiven Bereich bei. Die interne Quanteneffizienz wird dadurch nahezu unabhängig von der Stromdichte.

Insbesondere für den Fall, dass die vergrabene p-leitende Halbleiterschicht mit Magnesium dotiert ist, kann diese aufgrund der verbesserten Wasserstoff-Durchlässigkeit der darüber liegenden n-leitenden Halbleiterschicht verbessert aktiviert werden.

Das beschriebene Verfahren ist zur Herstellung eines weiter oben beschriebenen Halbleiterkörpers besonders geeignet. Im Zusammenhang mit dem Halbleiterkörper ausgeführte Merkmale können daher auch für das Verfahren herangezogen werden und umgekehrt.

Weitere Merkmale, vorteilhafte Ausgestaltungen und Zweckmäßigkeiten ergeben sich aus der folgenden Beschreibung der Ausführungsbeispiele in Verbindung mit den Figuren.

Es zeigen:
- Figur 1: ein erstes Ausführungsbeispiel für einen Halbleiterkörper in schematischer Schnittansicht;
- Figur 2: ein erstes Ausführungsbeispiel für einen Halbleiterchip mit einem Halbleiterkörper in schematischer Schnittansicht;
- Figur 3: ein zweites Ausführungsbeispiel für einen Halbleiterkörper in schematischer Schnittansicht; und
- die Figuren 4A und 4B: ein Ausführungsbeispiel für ein Verfahren zur Herstellung eines Halbleiterkörpers anhand von jeweils schematisch in Schnittansicht dargestellten Zwischenschritten.

Gleiche, gleichartige oder gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

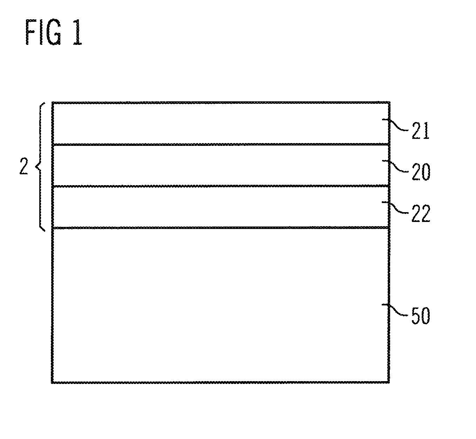

Ein erstes Ausführungsbeispiel für einen Halbleiterkörper ist in Figur 1 schematisch in Schnittansicht dargestellt. Der Halbleiterkörper 2 weist eine n-leitende Halbleiterschicht 21 und eine p-leitende Halbleiterschicht 22 auf. Zwischen der n-leitenden Halbleiterschicht und der p-leitenden Halbleiterschicht ist ein aktiver Bereich 20 ausgebildet, der zur Erzeugung von Strahlung vorgesehen ist.

Bei der Schichtenfolge, wie sie in Verbindung mit der Figur 1 beschrieben ist, handelt es sich beispielsweise um eine polaritätsinvertierte Struktur, wie diese weiter oben beschrieben ist, das heißt, in Wachstumsrichtung ergibt sich folgende Abfolge: p-leitende Schicht 22, aktiver Bereich 20, n-leitende Schicht 21. Die Wachstumsrichtung ist dabei vorzugsweise parallel zur kristallographischen C-Achse des Halbleiterkörpers.

Diese Schichtenabfolge nutzt die Polung der piezoelektrischen Felder, die sich im Halbleiterkörper 10 ausbilden, aus, um den Einfang von Ladungsträgern im aktiven Bereich 20 zu unterstützen. Die piezoelektrischen Felder tragen also bei dieser Abfolge zu einem verbesserten Einfang von Ladungsträgern im aktiven Bereich 20 bei. Die interne Quanteneffizienz beispielsweise von Mehrfachquantentöpfen im aktiven Bereich 20 wird dadurch nahezu unabhängig von der Stromdichte.

Die Halbleiterschichten des Halbleiterkörpers 2 sind vorzugsweise epitaktisch, etwa mittels MOVPE oder MBE, auf einem Aufwachssubstrat 50 abgeschieden.

Der Halbleiterkörper 2 basiert auf einem Nitrid-Verbindungshalbleitermaterial und kann beispielsweise zur Erzeugung von ultravioletter, blauer oder grüner Strahlung vorgesehen sein.

Als Aufwachssubstrat eignet sich beispielsweise Saphir, Siliziumcarbid, Galliumnitrid, Silizium, ein transparentes Oxid, etwa ZnO, oder Glas.

Die p-leitende Halbleiterschicht 22 enthält als p-Dotierstoff Magnesium. Die n-leitende Halbleiterschicht 21 enthält einen n-Dotierstoff, beispielsweise Silizium.

Weiterhin enthält die n-leitende Halbleiterschicht 21 einen weiteren Dotierstoff. Insbesondere Magnesium ist als weiterer Dotierstoff für die n-leitende Halbleiterschicht besonders geeignet. Mittels des weiteren Dotierstoffs ist die Durchlässigkeit der n-leitenden Halbleiterschicht 21 für Wasserstoff erhöht. Der weitere Dotierstoff kann also dem p-Dotierstoff der p-leitenden Halbleiterschicht entsprechen.

Der in die Halbleiterschicht 220 eingebaute Wasserstoff kann so vereinfacht durch die n-leitende Halbeiterschicht 21 hindurchtreten und aus dem Halbleiterkörper 2 entkommen. Der Grad der Aktivierung der p-leitenden Halbleiterschicht 22 kann somit auf einfache und reproduzierbare Weise verbessert werden.

Die Konzentration des weiteren Dotierstoffs in der n-leitenden Halbleiterschicht 21 beträgt vorzugsweise mindestens 1 x 10¹⁶ cm⁻³, besonders bevorzugt zwischen 1 x 10¹⁷ cm⁻³ und einschließlich 5 x 10¹⁸ cm⁻³, am meisten bevorzugt 1 x 10¹⁷ cm⁻³ und 2 x 10¹⁸ cm⁻³. So kann eine gute Durchlässigkeit für Wasserstoff bei gleichzeitig guter optischer Qualität der n-leitenden Halbleiterschicht erzielt werden.

Bezogen auf die Konzentration des n-Dotierstoffs beträgt die Konzentration des weiteren Dotierstoffs vorzugsweise höchstens 50 %. Eine zu starke Kompensation des n-Dotierstoffs durch den weiteren Dotierstoff kann so vermieden werden.

Die p-leitende Halbleiterschicht 22 ist zwischen dem Aufwachssubstrat 50 und der n-leitenden Halbleiterschicht 21 angeordnet. Die n-leitende Halbleiterschicht bedeckt die p-leitende Halbleiterschicht 22 auf der dem Aufwachssubstrat 50 abgewandten Seite. Die p-leitende Halbleiterschicht ist also als eine vergrabene Halbleiterschicht realisiert, die vor dem aktiven Bereich 20 und vor der n-leitenden Halbleiterschicht abgeschieden wurde.

Durch diese Reihenfolge von p-leitender Halbleiterschicht 22, aktivem Bereich 20 und n-leitender Halbleiterschicht 21 kann der Halbleiterkörper so ausgeführt sein, dass Ladungsträger vereinfacht in den aktiven Bereich injiziert werden und weiterhin die auftretenden piezoelektrischen Felder die Rekombination von Ladungsträgern im aktiven Bereich fördern können. Weiterhin kann die p-leitende Halbleiterschicht einen hohen Aktivierungsgrad aufweisen, so dass ein Halbleiterchip mit einem solchen Halbleiterkörper verbesserte optoelektronische Eigenschaften aufweisen kann.

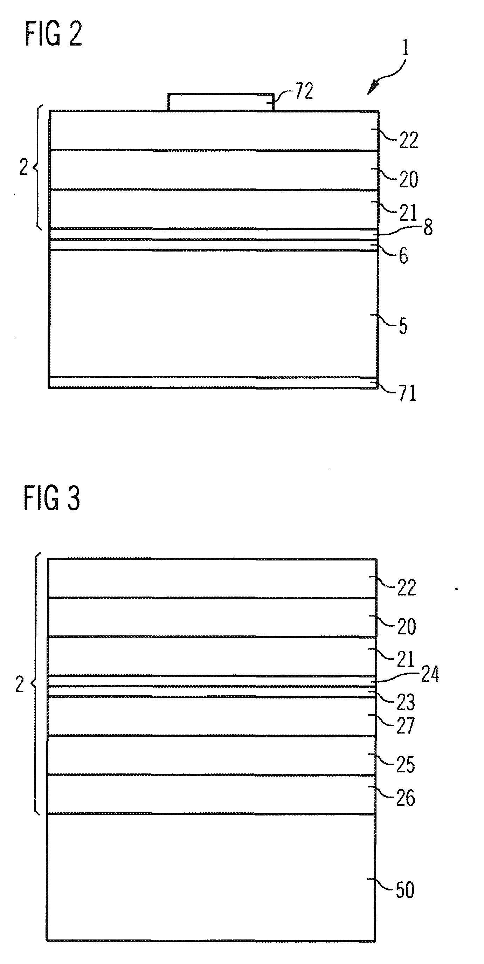

Ein Ausführungsbeispiel für einen Halbleiterchip ist in Figur 2 schematisch in Schnittansicht dargestellt. Der Halbleiterchip 1 weist einen Halbleiterkörper 2 auf. Der Halbleiterkörper kann insbesondere wie im Zusammenhang mit Figur 1 beschrieben ausgeführt sein.

Der Halbleiterkörper 2 ist auf einem Träger 5 angeordnet, der von dem Aufwachssubstrat für die Halbleiterschichtenfolge des Halbleiterkörpers 2 verschieden ist. Der Halbleiterkörper 2 ist mittels einer Verbindungsschicht 6 mit dem Träger 5 mechanisch stabil verbunden. Die Verbindungsschicht 6 kann beispielsweise eine Lotschicht oder eine elektrisch leitfähige Klebeschicht sein.

Weiterhin weist der Halbleiterchip 1 einen ersten Kontakt 71 und einen zweiten Kontakt 72 auf. Die Kontakte sind zur externen elektrischen Kontaktierung des Halbleiterchips 1 vorgesehen und derart angeordnet, dass im Betrieb des Halbleiterchips Ladungsträger von verschiedenen Seiten in den aktiven Bereich 20 injiziert werden können und dort unter Emission von Strahlung rekombinieren.

Zwischen der p-leitenden Halbleiterschicht 22 und dem zweiten Kontakt 72 kann eine Stromaufweitungsschicht ausgebildet sein (in der Figur nicht explizit dargestellt). Dadurch ist eine in laterale Richtung gleichmäßige Stromeinprägung über die p-leitende Halbleiterschicht in den aktiven Bereich 20 vereinfacht erzielbar.

Die Stromaufweitungsschicht erstreckt sich zweckmäßigerweise in lateraler Richtung über den zweiten Kontakt hinaus. Vorzugsweise bedeckt die Stromaufweitungsschicht die p-leitende Halbleiterschicht 22 vollständig oder im Wesentlichen vollständig.

Die Stromaufweitungsschicht kann als eine weitere n-leitende Halbleiterschicht ausgebildet sein und weiterhin bevorzugt eine höhere Querleitfähigkeit aufweisen als die p-leitende Halbleiterschicht. Die weitere n-leitende Halbleiterschicht ist vorzugsweise derart ausgeführt, dass sich zwischen dieser weiteren n-leitenden Halbleiterschicht und der p-leitenden Halbleiterschicht 22 ein Tunnelübergang ausbildet, über den die Ladungsträger im Betrieb des Halbleiterchips vom zweiten Kontakt 72 in die p-leitende Halbleiterschicht gelangen können.

Alternativ kann die Stromaufweitungsschicht außerhalb des Halbleiterkörpers angeordnet sein. Eine solche Stromaufweitungsschicht kann auf dem vorgefertigten Halbleiterkörper beispielsweise mittels Aufdampfens oder Aufsputterns aufgebracht werden.

In diesem Fall kann die Stromaufweitungsschicht beispielsweise ein TCO (transparent conductive oxide)-Material, etwa ITO (indium tin oxide) oder ZnO, enthalten oder aus einem solchen Material bestehen.

Auch eine metallische Stromaufweitungsschicht, die so dünn ist, dass sie für im aktiven Bereich erzeugte Strahlung transparent oder zumindest transluzent ist, ist denkbar. Selbstverständlich kann die Stromaufweitungsschicht auch mehrschichtig ausgebildet sein und beispielsweise eine TCO-Schicht und eine Metallschicht aufweisen.

Zwischen dem Halbleiterkörper 2 und dem Träger 5 ist eine Spiegelschicht 8 ausgebildet. An der Spiegelschicht kann im Betrieb des Halbleiterchips 1 im aktiven Bereich 20 erzeugte und in Richtung des Trägers 5 abgestrahlte Strahlung reflektiert werden. Die Gefahr einer Absorption der Strahlung im Träger kann so vermieden werden.

Die Spiegelschicht 8 kann beispielsweise ein Metall, etwa Silber, Aluminium, Rhodium oder Palladium enthalten oder aus einem solchen Material bestehen.

Der Träger 5 ist vorzugsweise elektrisch leitend ausgeführt. Beispielsweise kann der Träger 5 ein Halbleitermaterial, etwa Germanium, Galliumarsenid oder Silizium enthalten oder aus einem solchen Material bestehen. Davon abweichend kann der Träger 5 auch eine Keramik, etwa Aluminiumnitrid oder Bornitrid, enthalten oder aus einem solchen Material bestehen.

In dem in Figur 2 dargestellten Ausführungsbeispiel ist der Halbleiterchip 1 lediglich exemplarisch als ein Dünnfilm-Leuchtdiodenchip ausgeführt. Von dem gezeigten Ausführungsbeispiel abweichend kann das Aufwachssubstrat für den Halbleiterkörper 2 auch im Halbleiterchip verbleiben. Beispielsweise kann das Aufwachssubstrat bereichsweise oder vollflächig gedünnt oder bereichsweise entfernt sein.

Weiterhin können die Kontakte 71, 72 auch auf derselben Seite des Halbleiterchips angeordnet sein, so dass der Halbleiterchip von nur einer Seite her extern elektrisch kontaktierbar ist.

Die Kontakte 71, 72 sind zweckmäßigerweise elektrisch leitend ausgeführt und enthalten weiterhin bevorzugt ein Metall, etwa Titan, Platin, Nickel, Gold, Aluminium, Rhodium oder Palladium oder eine metallische Legierung mit zumindest einem der genanten Metalle.

Ein zweites Ausführungsbeispiel für einen Halbleiterkörper ist in Figur 3 schematisch in Schnittansicht dargestellt. Dieses zweite Ausführungsbeispiel entspricht im Wesentlichen dem in Zusammenhang mit Figur 1 beschriebenen ersten Ausführungsbeispiel.

Im Unterschied hierzu weist der Halbleiterkörper 2 einen weiteren aktiven Bereich 25, eine weitere n-leitende Halbleiterschicht 26 und eine weitere p-leitende Halbleiterschicht 27 auf. Zwischen dem aktiven Bereich 20 und dem weiteren aktiven Bereich 25 ist eine erste Tunnelschicht 23 und eine zweite Tunnelschicht 24 angeordnet. Die erste Tunnelschicht und die zweite Tunnelschicht bilden einen Tunnelkontakt, über den die aktiven Bereiche 20, 25 elektrisch zueinander in Serie verschaltet sind. Durch den zusätzlichen aktiven Bereich kann die insgesamt im Halbleiterkörper erzeugbare Strahlungsleistung erhöht werden. Die Tunnelschichten 23, 24 sind vorzugsweise bezüglich des Leitungstyps voneinander verschieden und weisen weiterhin bevorzugt eine hohe Dotierkonzentration, besonders bevorzugt von mindestens 1 x 10¹⁹ cm⁻³, auf.

Im Unterschied zu dem im Zusammenhang mit Figur 1 beschriebenen ersten Ausführungsbeispiel ist die p-leitende Halbeiterschicht 22 auf der dem Aufwachssubstrat 50 abgewandten Seite der n-leitenden Halbleiterschicht 21 angeordnet. Die n-leitende Halbleiterschicht 21 bedeckt in diesem Ausführungsbeispiel die p-leitende Halbleiterschicht 27 auf der dem Aufwachssubstrat 50 abgewandten Seite. Die p-leitende Halbleiterschicht ist also nach der n-leitenden Halbleiterschicht 21 auf dem Aufwachssubstrat abgeschieden.

Die weitere p-leitende Halbleiterschicht 27 kann hierbei im Wesentlichen wie die p-leitende Halbleiterschicht 22 ausgebildet sein. Bei der Aktivierung der p-leitenden Halbleiterschichten 22 liegt diese frei, so dass aus dieser Halbleiterschicht Wasserstoff ungehindert austreten kann.

Die weitere p-leitende Halbleiterschicht 27 ist auf der dem Träger 50 abgewandten Seite von der n-leitenden Halbleiterschicht 21 bedeckt. Aufgrund des in der n-leitenden Halbleiterschicht 21 ausgebildeten weiteren Dotierstoffs weist diese n-leitende Halbleiterschicht eine erhöhte Durchlässigkeit für Wasserstoff auf, so dass bei der Aktivierung der weiteren p-leitenden Halbleiterschicht 27 Wasserstoff durch die n-leitende Halbleiterschicht 21 hindurchtreten kann.

Zwischen der weiteren n-leitenden Halbleiterschicht 26 und dem Aufwachssubstrat 50 ist dagegen keine p-leitende Halbleiterschicht ausgebildet. Bei der weiteren n-leitenden Halbleiterschicht 26 ist die Wasserstoff-Durchlässigkeit daher von untergeordneter Bedeutung. Auf den weiteren Dotierstoff kann in dieser weiteren n-leitenden Halbleiterschicht daher verzichtet werden.

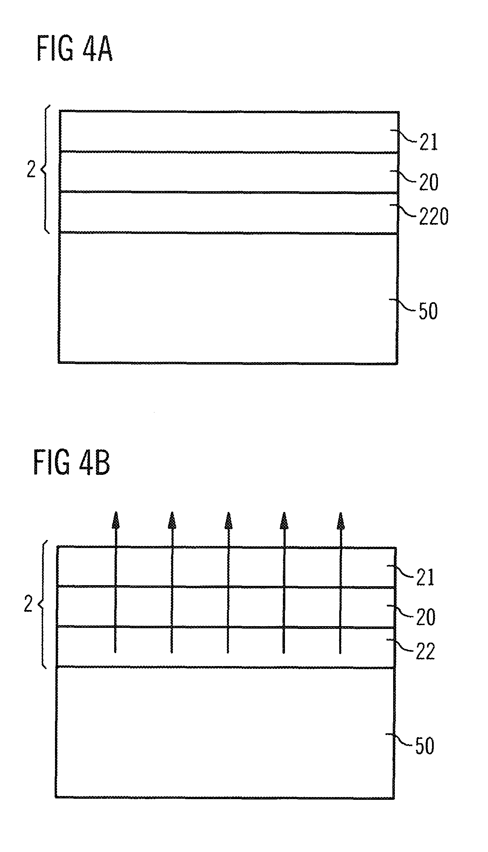

Ein Ausführungsbeispiel für ein Verfahren zur Herstellung eines Halbleiterkörpers ist in den Figuren 4A und 4B anhand von Zwischenschritten schematisch dargestellt. Das Verfahren wird exemplarisch anhand der Herstellung eines Halbleiterkörpers beschrieben, der wie im Zusammenhang mit Figur 1 beschrieben ausgeführt ist.

Auf einem Aufwachssubstrat 50 wird eine Halbleiterschicht 220 abgeschieden, die einen p-Dotierstoff und Wasserstoff enthält. Auf dieser Halbleiterschicht wird ein aktiver Bereich 20 und eine n-leitende Halbleiterschicht 21 abgeschieden. Die Halbleiterschicht, der aktive Bereich 20 und die n-leitende Halbleiterschicht 21 bilden den Halbleiterkörper 2. Nach der Abscheidung des Halbleiterkörpers wird die Halbleiterschicht 220 aktiviert. Dies kann beispielsweise thermisch erfolgen. Bei der Aktivierung kann, wie in Figur 4B schematisch durch Pfeile dargestellt, Wasserstoff aus der Halbleiterschicht durch den aktiven Bereich und die n-leitende Halbleiterschicht 21 hindurch diffundieren. Der Wasserstoff kann also auf der dem Aufwachssubstrat abgewandten Seite aus dem Halbleiterkörper 2 ausgetrieben werden.

## Patentansprüche

1. Halbleiterkörper (2) mit
- einer n-leitenden (21) Halbleiterschicht und
- einer p-leitenden Halbleiterschicht (22), bei dem
- die p-leitende Halbleiterschicht (22) einen p-Dotierstoff enthält,
- die n-leitende Halbleiterschicht (21) einen n-Dotierstoff und einen weiteren Dotierstoff enthält, und
**dadurch gekennzeichnet, dass** zwischen der p-leitenden Halbleiterschicht (22) und der n-leitenden Halbleiterschicht (21) ein aktiver, zur Strahlungserzeugung vorgesehener Bereich (20) und/oder ein Tunnelkontakt (23,24) ausgebildet ist.

2. Halbleiterkörper nach Anspruch 1,
bei dem der Tunnelkontakt eine erste Tunnelschicht (23) und
eine zweite Tunnelschicht (24) aufweist, wobei die Tunnelschichten bezüglich des Leitungstyps voneinander verschieden sind.

3. Halbleiterkörper nach einem der vorherigen Ansprüche,
bei dem die p-leitenden Halbleiterschicht (22) zwischen dem aktiven Bereich (20) und einem Träger (5) oder einem Aufwachssubstrat (50) angeordnet ist.

4. Halbleiterkörper nach einem der vorherigen Ansprüche,
der eine polaritätsinvertierte Struktur aufweist mit folgender Abfolge von Schichten:
- das Aufwachssubstrat (50),
- auf dem Aufwachssubstrat (50) die p-leitende Halbleiterschicht (22),
- auf der p-leitenden Halbleiterschicht (22) der aktive Bereich (20), und
- auf dem aktiven Bereich (20) die n-leitende Halbleiterschicht (21).

5. Halbleiterkörper nach einem der vorherigen Ansprüche,
bei dem der weitere Dotierstoff bezüglich des Materials und der Konzentration derart in der n-leitenden Halbleiterschicht (21) ausgebildet ist, dass eine Durchlässigkeit der n-leitenden Halbleiterschicht (21) für Wasserstoff erhöht ist.

6. Halbleiterkörper nach einem der vorherigen Ansprüche,
bei dem der weitere Dotierstoff in der n-leitenden Halbleiterschicht (21) als Akzeptor wirkt.

7. Halbleiterkörper nach einem der vorherigen Ansprüche,
bei dem der weitere Dotierstoff gleich dem p-Dotierstoff der p-leitenden Halbleiterschicht (22) ist.

8. Halbleiterkörper nach einem der vorherigen Ansprüche,
bei dem die Konzentration des weiteren Dotierstoffs in der der n-leitenden Halbleiterschicht (21) zwischen einschließlich 1 x 10¹⁷ cm⁻³ und einschließlich 5 x 10¹⁸ cm⁻³ beträgt.

9. Halbleiterkörper nach einem der vorherigen Ansprüche,
bei dem die Konzentration des weiteren Dotierstoff in der n-leitenden Halbleiterschicht (21) höchstens 50 % der Konzentration des n-Dotierstoffs beträgt.

10. Halbleiterkörper nach einem der vorherigen Ansprüche,
bei dem der Halbleiterkörper (2) den aktiven Bereich (20) und einen weiteren aktiven Bereich (25) aufweist, die jeweils zur Erzeugung von Strahlung vorgesehenen sind, wobei die n-leitende Halbleiterschicht (21) zwischen dem aktiven Bereich (20) und dem weiteren aktiven Bereich (25) ausgebildet ist.

11. Halbleiterkörper nach einem der vorherigen Ansprüche,
bei dem der Halbleiterkörper (2) auf einem nitridischen Verbindungshalbleitermaterial basiert.

12. Halbleiterchip (1) mit einem Halbleiterkörper (2) nach einem der Ansprüche 1 bis 9,der als Lumineszenzdioden-Chip oder als Laserdioden-Chip, insbesondere als Dünnfilm-Halbleiterchip ausgeführt ist.

13. Verfahren zur Herstellung eines Halbleiterkörpers (2) mit einer n-leitenden Halbleiterschicht (21), und einer p-leitenden Halbleiterschicht (22) mit den Schritten:
a) Abscheiden einer Halbleiterschicht (220), die einen p-Dotierstoff und Wasserstoff enthält;
b) Abscheiden der n-leitenden Halbleiterschicht (21), die einen n-Dotierstoff und einen weiteren Dotierstoff enthält; und
c) Aktivieren des p-Dotierstoffs der Halbleiterschicht (220) zum Ausbilden der p-leitenden Halbleiterschicht (22), wobei Wasserstoff aus der Halbleiterschicht (220) durch die n-leitende Halbleiterschicht (21) hindurchtritt, **dadurch gekennzeichnet, dass** zwischen der p-leitenden Halbleiterschicht (22) und der n-leitenden Halbleiterschicht (21) ein aktiver, zur Strahlungserzeugung vorgesehener Bereich (20) und/oder ein Tunnelkontakt (23,24) ausgebildet ist.

14. Verfahren nach Anspruch 13,
bei dem die Aktivierung in Schritt c) thermisch erfolgt.

15. Verfahren nach Anspruch 13 oder 14,
bei dem ein Halbleiterkörper (2) gemäß einem der Ansprüche 2 bis 11 hergestellt wird.

## Claims

1. Semiconductor body (2) comprising
- an n-conducting (21) semiconductor layer and
- a p-conducting semiconductor layer (22), wherein
- the p-conducting semiconductor layer (22) contains a p-type dopant,
- the n-conducting semiconductor layer (21) contains an n-type dopant and a further dopant, and
**characterized in that** an active region (20) provided for generating radiation and/or a tunnel contact (23, 24) are/is formed between the p-conducting semiconductor layer (22) and the n-conducting semiconductor layer (21).

2. Semiconductor body according to Claim 1,
wherein the tunnel contact comprises a first tunnel layer (23) and a second tunnel layer (24), wherein the tunnel layers differ from one another with regard to the conduction type.

3. Semiconductor body according to either of the preceding claims,
wherein the p-conducting semiconductor layer (22) is arranged between the active region (20) and a carrier (5) or a growth substrate (50).

4. Semiconductor body according to any of the preceding claims,
which has a polarity-inverted structure comprising the following sequence of layers:
- the growth substrate (50),
- the p-conducting semiconductor layer (22) on the growth substrate (50),
- the active region (20) on the p-conducting semiconductor layer (22), and
- the n-conducting semiconductor layer (21) on the active region (20).

5. Semiconductor body according to any of the preceding claims,
wherein the further dopant is embodied with regard to material and concentration in the n-conducting semiconductor layer (21) in such a way that a permeability of the n-conducting semiconductor layer (21) to hydrogen is increased.

6. Semiconductor body according to any of the preceding claims,
wherein the further dopant in the n-conducting semiconductor layer (21) acts as an acceptor.

7. Semiconductor body according to any of the preceding claims,
wherein the further dopant is identical to the p-type dopant of the p-conducting semiconductor layer (22).

8. Semiconductor body according to any of the preceding claims,
wherein the concentration of the further dopant in the n-conducting semiconductor layer (21) is between 1 × 10¹⁷ cm⁻³ and 5 × 10¹⁸cm⁻³ inclusive.

9. Semiconductor body according to any of the preceding claims,
wherein the concentration of the further dopant in the n-conducting semiconductor layer (21) is at most 50% of the concentration of the n-type dopant.

10. Semiconductor body according to any of the preceding claims,
wherein the semiconductor body (2) comprises the active region (20) and a further active region (25), which are in each case provided for generating radiation, wherein the n-conducting semiconductor layer (21) is formed between the active region (20) and the further active region (25).

11. Semiconductor body according to any of the preceding claims,
wherein the semiconductor body (2) is based on a nitridic compound semiconductor material.

12. Semiconductor chip (1) comprising a semiconductor body (2) according to any of Claims 1 to 9, which is embodied as a luminescence diode chip or as a laser diode chip, in particular as a thin-film semiconductor chip.

13. Method for producing a semiconductor body (2) comprising an n-conducting semiconductor layer (21) and a p-conducting semiconductor layer (22), comprising the following steps:
a) depositing a semiconductor layer (220) containing a p-type dopant and hydrogen;
b) depositing the n-conducting semiconductor layer (21) containing an n-type dopant and a further dopant; and
c) activating the p-type dopant of the semiconductor layer (220) in order to form the p-conducting semiconductor layer (22), wherein hydrogen from the semiconductor layer (220) passes through the n-conducting semiconductor layer (21),
**characterized in that** an active region (20) provided for generating radiation and/or a tunnel contact (23, 24) are/is formed between the p-conducting semiconductor layer (22) and the n-conducting semiconductor layer (21).

14. Method according to Claim 13,
wherein the activation in step c) is effected thermally.

15. Method according to Claim 13 or 14,
wherein a semiconductor body (2) according to any of Claims 2 to 11 is produced.

## Revendications

1. Corps semi-conducteur (2) présentant
- une couche semi-conductrice (21) à conduction n et
- une couche semi-conductrice (22) à conduction p,
- la couche semi-conductrice (22) à conduction p contenant une substance de dopage p,
- la couche semi-conductrice (21) à conduction n présentant une substance de dopage n et une autre substance de dopage,
**caractérisé en ce que**
une partie active (20) prévue pour produire un rayonnement et/ou un contact tunnel (23, 24) sont formés entre la couche semi-conductrice (22) à conduction p et la couche semi-conductrice (21) à conduction n.

2. Corps semi-conducteur selon la revendication 1, dans lequel le contact tunnel présente une première couche tunnel (23) et une deuxième couche tunnel (24), les couches tunnel étant différentes l'une de l'autre en termes de type de conduction.

3. Corps semi-conducteur selon l'une des revendications précédentes, dans lequel la couche semi-conductrice (22) à conduction p est disposée entre la partie active (20) et un support (5) ou un substrat de croissance (50).

4. Corps semi-conducteur selon l'une des revendications précédentes, qui présente une structure d'inversion de polarité dotée de la succession de couches suivante :
- le substrat de croissance (50),
- sur le substrat de croissance (50), la couche semi-conductrice (22) à conduction p,
- sur la couche semi-conductrice (22) à conduction p, la partie active (20) et
- sur la partie active (20), la couche semi-conductrice (21) à conduction n.

5. Corps semi-conducteur selon l'une des revendications précédentes, dans lequel le matériau et la concentration de l'autre substance de dopage dans la couche semi-conductrice (21) à conduction n sont sélectionnés pour augmenter la perméabilité de la couche semi-conductrice (21) à conduction n vis à vis de l'hydrogène.

6. Corps semi-conducteur selon l'une des revendications précédentes, dans lequel l'autre substance de dopage agit comme accepteur dans la couche semi-conductrice (21) à conduction n.

7. Corps semi-conducteur selon l'une des revendications précédentes, dans lequel l'autre substance de dopage est identique à la substance de dopage p de la couche semi-conductrice (22) à conduction p.

8. Corps semi-conducteur selon l'une des revendications précédentes, dans lequel la concentration de l'autre substance de dopage dans la couche semi-conductrice (21) à conduction n est comprise entre 1 x 10¹⁷ cm⁻³ inclus et 5 x 10¹⁸ cm⁻³ inclus.

9. Corps semi-conducteur selon l'une des revendications précédentes, dans lequel la concentration de l'autre substance de dopage dans la couche semi-conductrice (21) à conduction n représente au plus 50 % de la concentration de la substance de dopage n.

10. Corps semi-conducteur selon l'une des revendications précédentes, dans lequel le corps semi-conducteur (2) présente la partie active (20) et une autre partie active (25), toutes deux prévues pour produire un rayonnement, la couche semi-conductrice (21) à conduction n étant formée entre la partie active (20) et l'autre partie active (25).

11. Corps semi-conducteur selon l'une des revendications précédentes, dans lequel le corps semi-conducteur (2) est à base d'un matériau semi-conducteur à composé nitruré.

12. Puce semi-conductrice (1) présentant un corps semi-conducteur (2) selon l'une des revendications 1 à 9 et configurée comme puce de diode luminescente ou comme puce de diode laser, en particulier comme puce semi-conductrice à film mince.

13. Procédé de fabrication d'un corps semi-conducteur (2) qui présente une couche semi-conductrice (21) à conduction n et une couche semi-conductrice (22) à conduction p, le procédé comportant les étapes:
a) déposer une couche semi-conductrice (220) qui contient une substance de dopage p et de l'hydrogène,
b) déposer la couche semi-conductrice (21) à conduction n qui contient une substance de dopage n et une autre substance de dopage et
c) activer la substance de dopage p de la couche semi-conductrice (220) en vue de former la couche semi-conductrice (22) à conduction p, l'hydrogène provenant de la couche semi-conductrice (220) traversant la couche semi-conductrice (21) à conduction n, **caractérisé en ce que**
une partie active (20) prévue pour produire un rayonnement et/ou un contact tunnel (23, 24) sont formés entre la couche semi-conductrice (22) à conduction p et la couche semi-conductrice (21) à conduction n.

14. Procédé selon la revendication 13, dans lequel l'activation de l'étape c) s'effectue thermiquement.

15. Procédé selon les revendications 13 ou 14 pour fabriquer un corps semi-conducteur (2) selon l'une des revendications 2 à 11.
